# FASCICULE DE BREVET EUROPEEN

(11) **EP 0 368 740 B1**
(45) Date de publication et mention de la délivrance du brevet: **15.02.1995**
(21) Numéro de dépôt: 89403051.9
(22) Date de dépôt: 07.11.1989
(51) Int. Cl.: H01L 23/498, H01L 23/48, H01L 23/64

(54) **Boîtier de circuit intégré de haute densité**
Gehäuse für integrierte Schaltung hoher Dichte
High-density integrated-circuit housing

(30) Priorité: 08.11.1988 FR 8814542
(43) Date de publication de la demande: 16.05.1990
(73) Titulaire: BULL S.A., 92800 Puteaux (FR)
(72) Inventeur: Benavides, Eric, F-75016 Paris (FR); Guilhot, Agnès, F-75016 Paris (FR)
(74) Mandataire: Denis, Hervé

(56) Documents cités:
- EP-A- 0 214 307
- EP-A- 0 239 494
- EP-A- 0 282 617
- EP-A- 0 285 277
- DE-A- 3 706 251
- US-A- 4 680 613
- IBM TECHNICAL DISCLOSURE BULLETIN, vol. 21, no. 5, octobre 1978, pages 1895-1897, New York, US; S. MAGDO: "Low inductance module"

## Description

L'invention a pour objet un boîtier de circuit intégré de haute densité, encore appelé circuit VLSI (Very Large Scale Integration chip) ou puce, comprenant un support TAB (Tape-Automated Bonding) de circuit intégré, adapté au boîtier.

Les circuits intégrés actuels ordinaires sont des plaquettes semiconductrices sensiblement carrées, d'environ un centimètre de côté et pouvant porter jusqu'à 500 bornes périphériques. Le support TAB d'un tel circuit intégré comprend un substrat isolant porteur d'une pluralité de pattes rayonnantes, appelée araignée TAB. Le substrat est ordinairement fait d'un matériau plastique souple, tel que celui connu sous la marque déposée Kapton, et se compose d'un ou plusieurs cadres concentriques. Les pattes du support convergent vers une région centrale du substrat pour être connectées aux bornes d'entrée-sortie du circuit intégré selon une opération appelée ILB (Inner Lead Bonding), consistant ordinairement en un soudage par thermocompression. Le support TAB d'un circuit intégré est habituellement découpé d'un film de type cinématographique, appelé film TAB, comprenant une succession longitudinale d'araignées TAB et de perforations latérales servant à déplacer et à positionner le film.

L'un des problèmes actuels de l'encapsulation d'un circuit intégré de haute densité dans un boîtier concerne l'alimentation en énergie du circuit intégré. Les potentiels d'alimentation sont la masse et ordinairement une ou deux différentes valeurs prédéterminées. En cours de fonctionnement du circuit intégré, ces potentiels doivent rester stables en dépit des différentes valeurs d'intensité du courant demandé par les circuits appelés à fonctionner dans le circuit intégré. De ce fait, les pattes d'alimentation constituent autant de lignes de transmission électrique présentant une composante réactive d'auto-induction en réponse aux variations de courant. La composante d'auto-induction de chaque patte est donc proportionnelle à sa longueur. D'autre part, l'intensité du courant d'alimentation est actuellement élevée. Par exemple, certains circuits intégrés peuvent dissiper momentanément jusqu'à 6 watts sous une tension de 3 volts, nécessitant ainsi l'écoulement de deux ampères. Compte tenu de la grande densité des bornes du circuit intégré, les pattes doivent être étroites et très rapprochées les unes des autres. L'écoulement d'une forte intensité de courant d'alimentation doit donc se faire dans une pluralité de pattes d'alimentation. De surcroît, les faibles sections des pattes augmentent leur résistance ohmique.

La solution actuellement adoptée est celle décrite dans le document EP-A-0 239 494 et consiste à appliquer les potentiels d'alimentation sur des bornes massives respectives, extérieures au boîtier et connectées à l'intérieur de celui-ci à des plans conducteurs de potentiel respectifs. Les plans de potentiel sont associés à des condensateurs discrets de découplage, incorporés au boîtier, ou forment les plaques d'un condensateur de découplage. Ils sont aussi connectés aux pattes d'alimentation correspondantes, au plus près du circuit intégré. La longueur des pattes d'alimentation est ainsi réduite approximativement à la longueur séparant les bornes d'alimentation du circuit intégré des plans de potentiel avoisinants. Cette solution qui correspond à la partie précaractérisante de la revendication 1 a donc l'avantage de réduire l'impédance ohmique et la composante réactive d'auto-induction du circuit d'alimentation dans le boîtier. Elle aboutit au fait que seules les pattes de signaux sont longues et s'étendent sur tout le support pour être connectées à l'extérieur du boîtier.

L'utilisation de supports TAB portant de courtes pattes d'alimentation et de longues pattes de signaux pose en pratique le problème d'interférence de signaux circulant dans des pattes voisines. En effet, deux grandes pattes voisines de signaux sur un support TAB de haute densité sont sensiblement parallèles et très proches l'une de l'autre (de 50 à 100 microns) et constituent deux lignes électriques agissant mutuellement l'une sur l'autre. Une solution comme celle décrite dans le document EP-A-0 282 617 consiste à répartir les pattes de signaux en une pluralité de groupes isolés les uns des autres par des conducteurs à potentiels fixes, tels que des conducteurs d'alimentation. Cependant, l'allongement des pattes d'alimentation pour constituer des éléments de blindage électromagnétique entre deux groupes adjacents de pattes de signaux reposerait le problème de la composante réactive d'auto-induction de ces longues pattes d'alimentation.

L'invention donne une solution à ce problème, offrant ainsi l'avantage d'obtenir une composante d'auto-induction réduite et un blindage efficace entre pattes de signaux.

Un boîtier de circuit intégré de haute densité conforme à l'invention est défini par les caractéristiques de la revendication 1.

Les caractéristiques et avantages de l'invention ressortiront de la description qui suit, donnée à titre d'exemple et faite en référence aux dessins annexés.

Dans les dessins :
- la figure 1 est une demi-vue en coupe axiale partielle d'un boîtier conforme à l'invention pour un circuit intégré de haute densité, le boîtier incluant un support TAB de circuit intégré et étant monté sur une carte d'interconnexion adaptée au boîtier ;
- la figure 2 est une vue en perspective éclatée du boîtier et de la carte représentée sur la figure 1 ;
- la figure 3 est une vue en plan, schématique et partielle, d'un film TAB, duquel a été prélevé le support TAB du circuit intégré incorporé au boîtier représenté sur les figures 1 et 2 ; et
- les figures 4 et 5 sont respectivement des vues en coupe suivant les lignes IV-IV et V-V du film TAB représenté sur la figure 3.

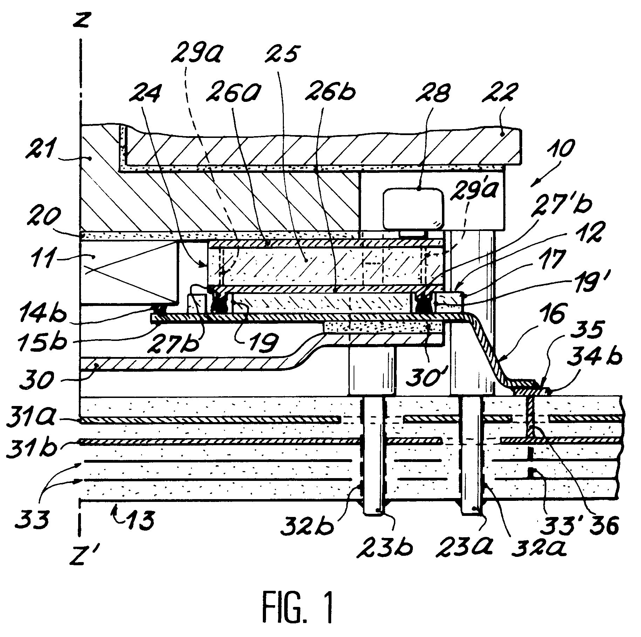

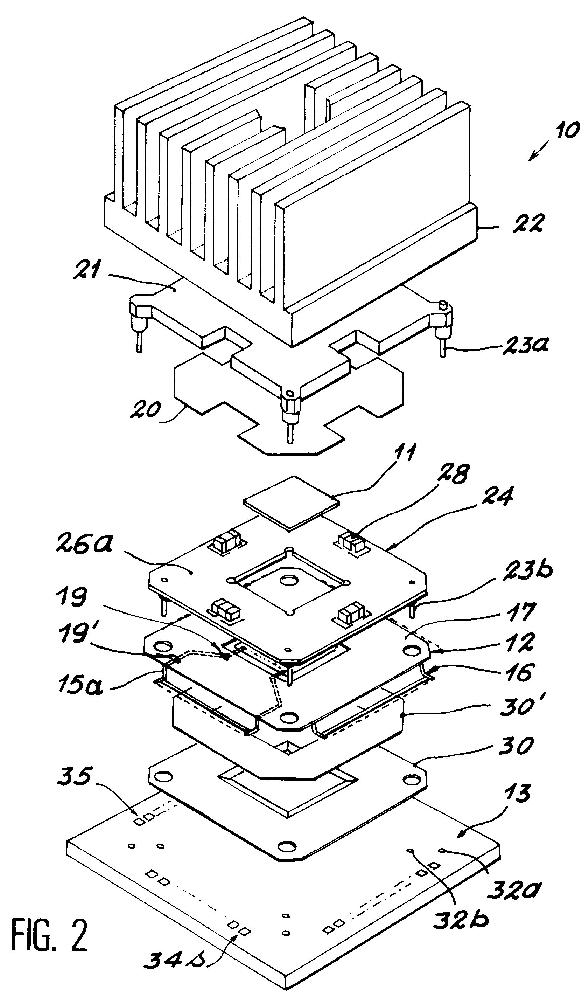

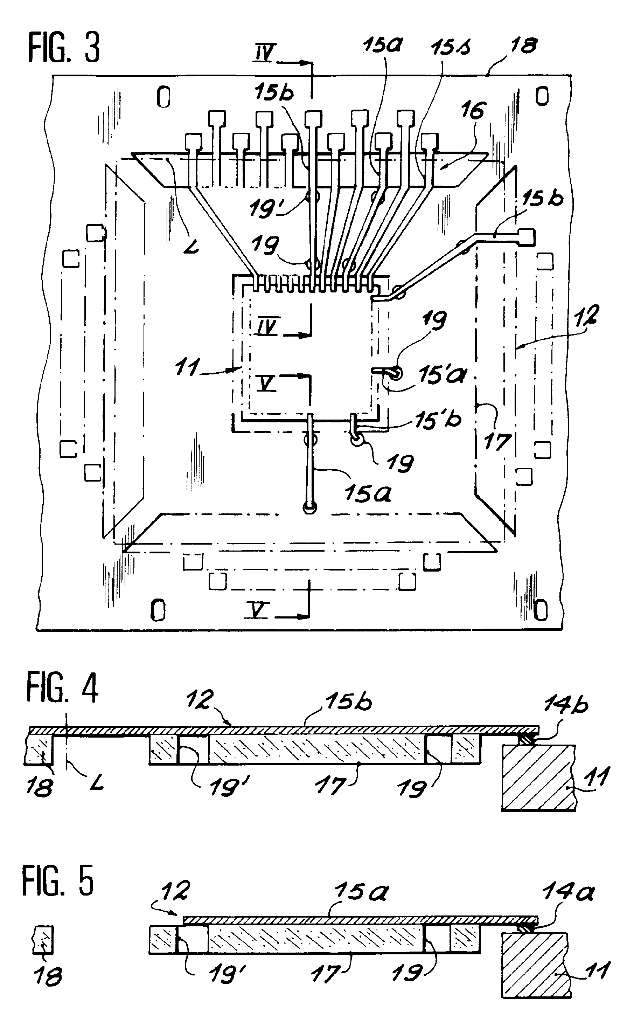

Les figures 1 et 2 illustrent le mode préféré de réalisation conforme à l'invention d'un boîtier 10 de circuit intégré 11 monté sur un support TAB 12. Le boîtier 10 représenté sur la figure 1 est une demi-vue en coupe médiane et axiale selon l'axe ZZ′ passant perpendiculairement au circuit intégré 11 en son centre. Il est d'autre part illustré dans sa position finale de connexion avec une carte d'interconnexion 13, illustrée schématiquement et partiellement sous la forme d'une carte de circuits imprimés. Les figures 3, 4 et 5 illustrent des exemples de réalisation du support TAB 12 inclus dans le boîtier 10.

En référence aux figures 3, 4 et 5, le circuit intégré 11 porte sur sa face active des bornes d'entrée-sortie 14 périphériques, généralement disposées en une ligne ou en quinconce. Les bornes 14 se répartissent en bornes de signaux 14s (non visibles sur les figures) et en bornes d'alimentation 14a, 14b correspondant respectivement à deux potentiels d'alimentation Ua et Ub, avec Ua = 0 volt (la masse) et Ub = +3 volts. Les bornes 14 sont fixées aux extrémités intérieures de conducteurs (pattes) respectifs 15 assemblés en un faisceau (araignée TAB) 16 sur une face d'un substrat souple 17 électriquement isolant. On distingue les pattes de signaux 15s fixées aux bornes de signaux 14s, des longues pattes d'alimentation 15a, 15b partant de bornes d'alimentation respectives 14a, 14b, et des courtes pattes d'alimentation 15′a, 15′b respectivement fixées aux autres bornes d'alimentation 14a, 14b du circuit intégré 11. Le substrat 17 illustré est formé d'un seul cadre pour la commodité des dessins, sachant qu'en pratique il se compose habituellement de plusieurs cadres concentriques à l'axe ZZ′ du circuit intégré 11. Le support TAB 12 a été découpé d'un film TAB 18 suivant la ligne L indiquée par un trait fantôme. Sur un support classique, seules les pattes de signaux 15s sont étendues jusqu'au film 18 et coupées suivant la ligne L, étant donné que les pattes d'alimentation sont très courtes, comme les pattes 15′a et 15′b illustrées dans la figure 3. D'une manière générale, les pattes d'alimentation 15′a, 15′b s'arrêtent à proximité du circuit intégré 11, à la périphérie intérieure du cadre 17 du substrat. Dans l'exemple illustré dans la figure 3, les pattes courtes 15′a, 15′b s'arrêtent au niveau de trous 19 ménagés dans la périphérie intérieure du cadre 17, et les pattes longues 15a, 15b passent au niveau de trous similaires 19 ménagés dans la périphérie intérieure du cadre 17. Le support TAB 12 est ainsi adapté à l'exemple de réalisation du boîtier 10 qui va maintenant être décrit.

Dans le boîtier 10 représenté sur les figures 1 et 2, le circuit intégré 11 a sa base fixée par un joint conducteur 20 à une embase 21 faite en un matériau électriquement et thermiquement conducteur, tel que le cuivre ou l'aluminium. L'embase 21 est une plaque rigide sensiblement carrée, coaxiale à l'axe ZZ′ et pourvue d'une colonne coaxiale pour la fixation d'un radiateur 22. Les coins de l'embase 21 se prolongent suivant ses diagonales pour former quatre bras porteurs de quatre bornes d'alimentation 23a constituées par des pieux conducteurs perpendiculaires à l'embase. Le boîtier 10 comporte un dispositif de découplage 24 composé d'un cadre isolant 25 pourvu sur ses deux faces de deux plans conducteurs respectifs 26a, 26b en liaison avec des îlots conducteurs correspondants 27b ainsi qu'avec quatre condensateurs 28. Le dispositif de découplage 24 entoure coaxialement le circuit intégré 11. Le plan conducteur 26a est fixé à l'embase 21 par le joint 20 dûment étendu. De l'autre côté, le plan conducteur 26b est en liaison avec quatre bornes d'alimentation 23b formées de pieux fixés aux quatre côtés du cadre 25. Contre le plan conducteur 26b s'appuie le substrat 17 du support TAB 12. Les îlots 27b sont disposés à la périphérie intérieure du cadre 25, en correspondance avec les trous 19 dans le substrat 17 pour être en contact avec les pattes d'alimentation respectives 15a, 15b, 15′a, 15′b de l'araignée TAB 16. En pratique, les îlots 27b sont des extensions du plan conducteur 26b et autres îlots sont mis en liaison avec le plan conducteur 26a par l'intermédiaire de piliers 29a traversant le cadre 25. Le boîtier 10 est fermé par un capot 30, avantageusement fait d'un matériau conducteur et fixé mécaniquement et électriquement aux pieux 23b, tout en étant isolé de l'araignée 16 par un joint 30′.

La carte d'interconnexion 13 sur laquelle vient s'appliquer le boîtier 10 se compose de deux plans conducteurs 31a, 31b mis respectivement aux potentiels d'alimentation Ua et Ub, de trous métallisés 32a, 32b en liaison respective avec les plans conducteurs 31a, 31b et avec les pieux d'alimentation 23a, 23b du boîtier 10, et d'un réseau d'interconnexion de signaux 33 formé de couches conductrices telles que les deux couches illustrées par un trait continu dans la figure 1 et de plages de connexion 34s alignées selon une couronne 35 concentrique à l'axe ZZ′ et placées en correspondance avec les extrémités extérieures des pattes de signaux 15s de l'araignée TAB 16 du boîtier 10. Les plages de connexion 34s sont reliées au réseau d'interconnexion de signaux 33 par des piliers conducteurs 33, illustrés par un trait tireté dans la figure 1.

Selon une caractéristique de l'invention, au moins une partie de l'ensemble des pattes d'alimentation de l'araignée TAB 16 est faite de longues pattes d'alimentation 15a, 15b connectées à la fois sur les îlots périphériques intérieurs 27b du dispositif de découplage 24 du boîtier 10 et sur des îlots périphériques extérieurs 27′b du dispositif de découplage 24. Dans le support TAB 12 illustré dans la figure 3 et monté dans le boîtier 10 de la figure 1, des pattes courtes d'alimentation 15a, 15b subsistent, et les pattes longues d'alimentation 15a, 15b viennent au niveau de trous 19′ ménagés dans la périphérie extérieure du substrat 17 du support TAB 12. Les îlots périphériques extérieurs 27′b sont des extensions du plan de potentiel 26b et autres îlots sont reliés au plan de potentiel 26a par des piliers respectifs 29′a traversant le cadre 25. La connexion des pattes d'alimentation dans les trous 19, 19′ est faite de préférence par un brasage étain-plomb sur les îlots correspondants surélevés par rapport au plan conducteur 26b.

La figure 4 est une vue en coupe partielle de détail agrandi du film 18 représenté sur la figure 3, ayant servi à la fabrication du boîtier représenté sur la figure 1. Selon ce mode de réalisation, les pattes d'alimentation 15a, 15b sont étendues de la même manière que les pattes de signaux 15s de l'araignée TAB 16. Dans ce cas, les extrémités extérieures de l'araignée TAB 16 du boîtier 10 sont connectées à des plages correspondantes 34a, 34b de la carte 13. Les plages 34a, 34b sont réparties parmi les plages de signaux 34s dans la couronne 35. Les plages 34a, 34b sont reliées aux plans de potentiel respectifs 31a, 31b par l'intermédiaire de piliers conducteurs 36.

Selon un mode de réalisation avantageux, les pattes d'alimentation allongées 15a, 15b sont disposées parmi les pattes de signaux 15s pour servir d'éléments de blindage électromagnétique entre groupes de pattes de signaux. Comme représenté en correspondance avec le côté haut du circuit intégré 11 représenté sur la figure 3, un conducteur d'alimentation allongé 15a ou 15b sépare deux groupes adjacents de pattes de signaux. Pour la clarté des dessins, les groupes illustrés ne se composent que de deux pattes de signaux. En pratique, chaque groupe se compose évidemment d'un nombre plus important de pattes de signaux 15s, ce nombre pouvant légèrement varier entre groupes adjacents.

En conclusion, l'allongement des pattes d'alimentation 15a, 15b dans une araignée TAB 16 et leur connexion à la périphérie intérieure et extérieure des plans conducteurs 26a, 26b entourant le circuit intégré 11 résout le problème de blindage électromagnétique entre groupes de pattes de signaux 15s. Bien entendu, une longue patte d'alimentation seule 15a ou 15b présente une plus grande self-induction. Grâce à l'invention, la majeure partie de la longueur de la patte allongée est shuntée par un plan conducteur présentant une self-induction négligeable. De plus, la self-induction totale de l'ensemble des longues pattes d'alimentation 15a, 15b a la valeur de la self-induction d'une longue patte shuntée conformément à l'invention, divisée par le nombre total des longues pattes. Il s'ensuit finalement que la self-induction totale du circuit d'alimentation dans un boîtier 10 conforme à l'invention est sensiblement égale à celle d'un boîtier classique.

Le mode de réalisation illustré dans les figures 1, 2, 3, 4 et 6 peut recevoir diverses variantes. Notamment, les courtes pattes d'alimentation 15′a, 15′b dans l'araignée 16 représentée sur la figure 3 peuvent être éliminées pour que l'ensemble des pattes d'alimentation soit prolongé pour servir d'éléments de blindage entre groupes de pattes de signaux 15s. D'autre part, le prolongement des pattes d'alimentation peut se limiter à leur connexion périphérique extérieure aux îlots 27′b avec les plans conducteurs 26a, 26b du boîtier 10. Cette variante est représentée sur la figure 5. Bien entendu, les variantes peuvent coexister dans une même araignée.

Par ailleurs, la réalisation du boîtier 10 illustré dans les figures 1 et 2 nécessite le percement des trous 19 et 19′ dans le substrat 17 du support TAB 12 pour la connexion des pattes d'alimentation avec les plans conducteurs respectifs du dispositif de découplage dans le boîtier. Cependant, pour d'autres configurations du dispositif de découplage dans un boîtier de circuit intégré de haute densité, dans lequel les îlots 27b et 27′b sont sur une même face électriquement isolée et distante des plans conducteurs 26a et 26b, l'araignée TAB 16 pourrait s'appliquer directement contre cette face, avec le substrat 17 placé vers le couvercle 30. Par conséquent, la connexion des îlots avec les longues pattes d'alimentation correspondantes pourrait se faire directement sans nécessiter le percement des trous dans le substrat 17. Par ailleurs, il est évident qu'un ensemble de trous 19 ou 19′ peut être substitué à une fente, ménagée par exemple dans chaque côté du substrat 17. Eventuellement, l'ensemble des trous 19 ou 19′ pourrait être formé par l'espace de deux cadres adjacents divisant le substrat 17. Le percement de trous sous les pattes d'alimentation est donc une expression qui comprend ces extensions. Pour ces extensions, les trous s'étendent alors sous les pattes de signaux.

## Revendications

1. Boîtier (10) de circuit intégré de haute densité, comprenant un circuit intégré (11), une araignée TAB (16) portée par un substrat isolant (17) concentrique au circuit intégré (11) et formée de longues pattes de signaux(15s) et d'une pluralité de pattes d'alimentation (15a, 15b, 15′a, 15′b), toutes connectées au circuit intégré, et des plans de potentiel d'alimentation (26a, 26b) parallèles au circuit intégré (11) et à l'araignée TAB (16) et s'étendant entre une périphérie intérieure proche du circuit intégré (11) et une périphérie extérieure, les pattes d'alimentation (15a, 15b, 15′a, 15′b) étant connectées, à proximité du circuit intégré, à la périphérie intérieure des plans de potentiel (26a, 26b) respectifs, caractérisé en ce que au moins une partie des pattes d'alimentation (15a, 15b) s'étendent au moins jusqu'à la périphérie extérieure des plans de potentiel (26a, 26b) respectifs pour y être connectées à proximité de cette périphérie extérieure et sont disposées de façon à servir de blindage entre groupes de pattes de signaux (15s).

2. Boîtier selon la revendication 1, caractérisé en ce que les pattes d'alimentation de ladite partie (15a, 15b) s'étendent au-delà de la périphérie extérieure des plans de potentiel (26a, 26b) et ont les mêmes longueurs que celles des pattes de signaux (15s).

3. Boîtier selon la revendication 1 ou 2, caractérisé en ce que d'autres de ladite pluralité des pattes d'alimentation (15′a, 15′b) ont une longueur limitée à la périphérie intérieure des plans de potentiel (26a, 26b).

4. Boîtier selon l'une des revendications 1 à 3, dans lequel le substrat isolant (17) est percé (en 19) à sa périphérie intérieure sous ladite pluralité de pattes d'alimentation (15a, 15b, 15′a, 15′b), caractérisé en ce que le substrat (17) est aussi percé (en 19′) à sa périphérie extérieure sous au moins ladite partie des pattes d'alimentation (15a, 15b) qui sont réparties sensiblement uniformément parmi les pattes de signaux (15s).

5. Boîtier selon la revendication 4, caractérisé en ce que ladite partie des pattes d'alimentation (15a, 15b) ont une longueur limitée au percement (19′) placé sous elles à la périphérie extérieure du substrat (17).

## Patentansprüche

1. Gehäuse (10) für eine hochintegrierte Schaltung, mit einer integrierten Schaltung (11), einer zur integrierten Schaltung (11) konzentrischen TAB-Leiterspinne (16), die von einem isolierenden Substrat (17) getragen und mit langen Signalanschlußbeinen (15s) sowie einer Anzahl von Versorgungsanschlußbeinen (15a, 15b, 15′a, 15′b) gebildet ist, die alle mit der integrierten Schaltung verbunden sind, sowie mit Versorgungspotentialflächen (26a, 26b), die parallel zur integrierten Schaltung (11) und zur TAB-Leiterspinne (16) sind und sich zwischen einem Innenumfang in der Nähe der integrierten Schaltung (11) und einem Außenumfang erstrecken, wobei die Versorgungsanschlußbeine (15a, 15b, 15′a, 15′b) in der Nähe der integrierten Schaltung mit dem Innenumfang der jeweiligen Potentialfläche (26a bzw. 26b) verbunden sind, dadurch gekennzeichnet, daß sich wenigstens eine Teilmenge (15a, 15b) der Versorgungsanschlußbeine bis zum Außenumfang der Potentialflächen (26a, 26b) erstrecken, um dort in der Nähe dieses Außenumfanges angeschlossen zu werden, und so angeordnet sind, daß sie als Abschirmung zwischen den Signalanschlußbeinen (15s) dienen.

2. Gehäuse nach Anspruch 1, dadurch gekennzeichnet, daß sich die Versorgungsanschlußbeine (15a, 15b) der Teilmenge über den Außenumfang der Potentialflächen (26a, 26b) hinaus erstrecken und die gleichen Längen wie die Signalanschlußbeine (15s) haben.

3. Gehäuse nach Anspruch 1 oder 2, dadurch gekennzeichnet, daß die anderen Versorgungsanschlußbeine (15′a, 15′b) der Anzahl von Versorgungsanschlußbeinen eine Länge haben, die auf den Innenumfang der Potentialflächen (26a, 26b) begrenzt ist.

4. Gehäuse nach einem der Ansprüche 1 bis 3, bei dem das isolierende Substrat (17) an seinem Innenumfang unter der Anzahl von Versorgungsanschlußbeinen (15a, 16b, 15′a, 15′b) durchbrochen ist (bei 19), dadurch gekennzeichnet, daß das Substrat (17) auch an seinem Außenumfang wenigstens unter den Versorgungsanschlußbeinen (15a, 15b) der Teilmenge durchbrochen ist (bei 19′), die im wesentlichen gleichförmig zwischen den Signalanschlußbeinen (15s) verteilt sind.

5. Gehäuse nach Anspruch 4, dadurch gekennzeichnet, daß die Versorgungsanschlußbeine (15a, 15b) der Teilmenge eine Länge haben, die auf den unter ihnen am Außenumfang des Substrats (17) angeordneten Durchbruch (19′) begrenzt ist.

## Claims

1. A very large-scale integrated circuit package (10), comprising an integrated circuit (11), a TAB spider (16) carried on an insulating substrate (17) concentric to the integrated circuit 11) and formed of long signal tabs (15s) and a plurality of supply tabs (15a, 15b, 15′a, 15′b), all connected to the integrated circuit, and supply potential planes (26a, 26b) parallel to the integrated circuit (11) and to the TAB spider (16) and extending between an inner periphery close to the integrated circuit (11) and an outer periphery, the supply tabs (15a, 15b, 15′a, 15′b) being connected, in the vicinity of the integrated circuit, to the inner periphery of the respective potential planes (26a, 26b), characterised in that at least one portion of the supply tabs (15a, 15b) extend at least to the outer periphery of the respective potential planes (26a, 26b) so as to be connected thereto in the vicinity of this outer periphery, and are arranged so as to serve as a shielding between groups of signal tabs (15s).

2. A package according to Claim 1, characterised in that the supply tabs of said portion (15a, 15b) extend beyond the outer periphery of the potential planes (26a, 26b) and have the same lengths as those of the signal tabs (15s).

3. A package according to Claim 1 or 2, characterised in that others among said plurality of supply tabs (15′a, 15′b) have a length limited to the inner periphery of the potential planes (26a, 26b).

4. A package according to one of Claims 1 to 3, in which the insulating substrate (17) is perforated (at 19) at its inner periphery under said plurality of supply tabs (15a, 15b, 15′a, 15′b), characterised in that the substrate (17) is also perforated (at 19′) at its outer periphery under at least said portion of the supply tabs (15a, 15b) which are distributed substantially uniformly among the signal tabs (15s).

5. A package according to Claim 4, characterised in that said portion of the supply tabs (15a, 15b) have a length limited to the perforation (19′) positioned under them at the outer periphery of the substrate (17).
